# EUROPEAN PATENT SPECIFICATION

(11) **EP 1 410 433 B1**
(45) Date of publication and mention of the grant of the patent: **23.03.2005**
(21) Application number: 02787170.6
(22) Date of filing: 16.07.2002
(51) Int. Cl.: H01L 21/332

(54) **SUPPORT WITH INTEGRATED DEPOSIT OF GAS ABSORBING MATERIAL FOR MANUFACTURING MICROELECTRONIC, MICROOPTOELECTRONIC OR MICROMECHANICAL DEVICES**
TRÄGER MIT INTEGRIERTER ABSCHEIDUNG VON GASABSORBIERENDEM MATERIAL ZUR HERSTELLUNG VON MIKROELEKTRONISCHEN, MICROOPTOELEKTRONISCHEN ODER MIKROMECHANISCHEN BAUELEMENTEN
SUPPORT AVEC DEPOT INTEGRE DE MATERIAU ABSORBANT LES GAZ POUR LA FABRICATION DE DISPOSITIFS MICROELECTRONIQUES, MICROOPTOELECTRONIQUES ET MICROMECANIQUES

(30) Priority: 20.07.2001 IT MI20011557; 03.04.2002 IT MI20020689
(43) Date of publication of application: 21.04.2004
(73) Proprietor: SAES GETTERS S.p.A., 20020 Lainate (Milano) (IT)
(72) Inventor: AMIOTTI, Marco, I-27029 Vigevano (IT)
(74) Representative: Adorno, Silvano
(86) International application number: PCT/IT2002/000465
(87) International publication number: WO 2003/009317

(56) References cited:
- EP-A- 0 837 502
- WO-A-00/61832
- US-A- 3 214 381
- US-A- 4 630 095

## Description

The present invention relates to a support for manufacturing microelectronic, microoptoelectronic or micromechanical devices with integrated deposit of gas absorbing material.

Microelectronic devices (also called integrated electronic circuits, indicated in the field with the abbreviation ICs) are the base of the whole integrated electronic industry. Microoptoelectronic devices comprise, for example, new generation infrared radiation (IR) sensors which, unlike traditional ones, do not require cryogenic temperatures for their operation. These IR sensors are formed of an array of semiconductor material deposits, for example silicon, arranged in an evacuated chamber. Micromechanical devices (better known in the field under the definition "micromachines" or its abbreviation MMs) are in developing step for applications such as miniaturized sensors or actuators: typical examples of micromachines are microaccelerometers, used as sensors to activate automobile airbags, micromotors, having gears and sprocket wheels of the size of a few microns (µm), or optic switches, wherein a mirror surface with a size of the order of a few tens microns can be moved between two different positions, directing a light beam along two different directions, one corresponding to the "on" condition and the other to the "off" condition of an optical circuit In the following, these devices will also all be referred to with the general definition of solid state devices.

ICs are manufactured by a technology comprising operations of deposit on a planar support of layers of material with different electric (or magnetic) functionality, alternated to selective removals thereof. The same techniques of depositions and selective removals are applied to microoptoelectronic or micromechanical devices construction as well. These are generally contained in housings formed, in their turn, with the same techniques. The support most commonly used in these productions is a silicon "slice" (said "wafer" in the field), about 1 mm thick and with a diameter up to 30 cm. On each of these wafers a very high number of devices is constructed; then, at the end of the manufacturing process, from these slices are separated, by mechanical or laser cut, the single devices in the case of micromachines, or parts including an array of some tens of devices in the IR sensors case.

The deposition steps are carried out with such techniques as chemical deposition from vapor state, generally defined "CVD" from "Chemical Vapor Deposition"; physical deposition from vapor state or "PVD", from "Physical Vapor Deposition", the latter commonly indicated also as "sputtering". Generally, selective removals are carried out through chemical or physical attacks with proper masking, as it is well known in the field.

The integrated circuits and the micromachines are then encapsulated in polymeric, metallic or ceramic materials, essentially for mechanical protection reasons, before being inserted in the final destination apparatus (a computer, an automobile, etc.). On the contrary, IR radiation sensors are generally comprised in a chamber, facing one wall thereof defined as "window", transparent to the IR radiation.

In some kinds of integrated circuits it is important to be able to control the gas diffusion in solid state devices: it is for example the case of ferroelectric memories, wherein hydrogen, diffusing through device layers, can reach the ferroelectric material (generally a ceramic oxide, such as lead titanate-zirconate, strontium-bismuth tantalate or titanate, or bismuth-lanthanum titanate), altering its correct behavior.

Still more important is gas control and elimination in IR sensors and in micromachines. In the case of IR sensors, the gases possibly present in the chamber can either sorb part of the radiation or transport heat by convection from the window to the array of silicon deposits, modifying the measure. In micromachines, the mechanical friction between gas molecules and the moving part, due to the very small size of the latter, can lead to sensible deviations from the device's ideal operation; moreover, polar molecules such as water can cause phenomena of adhesion between the moving part and other parts, for example the support thereof, thus causing the device's failure. In the IR sensors with arrays of silicon deposits or in the micromachines, it is therefore fundamental to be capable of ensuring the housing to remain in vacuum for the whole device life.

In order to minimize the gas amount in these devices, their production is usually conducted in vacuum chambers and resorting to pumping steps before the packaging thereof. Anyway the problem is not completely solved in this way, because the same materials which form the devices can release gases, or these can permeate from outside during the device life.

To remove also the gases entering in solid state devices during their life, it has been proposed the use of materials that can sorb these. These materials comprise those commonly referred to as "getters", generally metals such as zirconium, titanium, vanadium, niobium or tantalum, or alloys thereof with other transition elements, rare earths or aluminum, having a strong chemical affinity towards gases such as hydrogen, oxygen, water, carbon oxides and in some cases nitrogen; and the drier materials, specific for moisture absorption, among which mainly the oxides of alkali or alkaline-earth metals. The use of materials absorbing gases, particularly hydrogen, in ICs, is described for instance in patent US-A-5,760,433 and in published Japanese patent applications JP-11-040761 and JP-2000-40799; their use in IR sensors is described for example in patent US 5,921,461; finally, the use of gas absorbing materials in micromachines is described for example in the article "Vacuum packaging for microsensors by glass-silicon anodic bonding" by H. Henmi et al., published on technical journal Sensors and Actuators A, vol. 43 (1994), at pages 243-248.

Localized deposits of gas absorbing materials can be obtained by CVD or sputtering during solid state devices productive steps. However, this procedure is not very appreciated by manufacturers of these devices, since gas absorbing material deposition during devices production implies the need that the total process is added with a step of localized deposition of this material, generally carried out through the operations of resin deposition, resin local sensitization through radiations (generally UV), selective removal of the photosensitized resin, gas absorbing material deposition and subsequent removal of the resin and of the absorbing material thereon deposed, leaving the gas absorbing material deposit in the area from which the photosensitized resin had been removed. Moreover, the gas absorbing material deposit in the production line has the disadvantage that increasing the number of different steps of the process and of the materials therein used, also the risk of "cross-pollution" among the different chambers in which said different steps are carried out increases, with following possible increase of waste products because of contamination.

WO 0061832 discloses a support with integrated deposit of gas absorbing material for manufacture of micro-devices comprising a base with mechanical functions and a continuous deposit of a getter material.

The object of the present invention is to overcome the above-described problems of the prior art and, particularly, to simplify the manufacturing of solid state devices.

This object is achieved according to the present invention with a support for manufacturing microelectronic, microoptoelectronic or micromechanical devices with integrated deposit of gas absorbing material, formed of a base having the function of a mechanical backing, a continuous or discontinuous deposit of a gas absorbing material on a surface of said base, said gas absorbing material being selected from a getter material or a drier material and a layer totally covering said gas absorbing material deposit, made with a material compatible with the production of microelectronic, microoptoelectronic or micromechanical devices or parts thereof.

The support of the invention is practically similar to silicon wafers commonly used in industry, having, however, gas absorbing material (in the form of continuous layer or discrete deposits) ''buried'' under the surface on which the microelectronic or micromechanical devices are formed through above-mentioned techniques of solid materials deposition and removal.

The invention will be described below with reference to the drawings in which:
- Fig. 1 shows a perspective, partially cut-out view of a first possible support according to the invention;
- Fig. 2 shows a perspective, partially cut-out view of a second possible support according to the invention;
- Figs 3 to 11 represent some ways to use the supports of the invention.

For the sake of description clarity, in the drawings the supports according to the invention are represented with an extremely exaggerated height-diameter ratio, with respect to real dimensions. Moreover, in the drawings, supports are always represented with a wafer geometry, that is a low disk of material, because this is the geometry commonly adopted by the producers of solid state devices, but this geometry could be also different, for example square or rectangular.

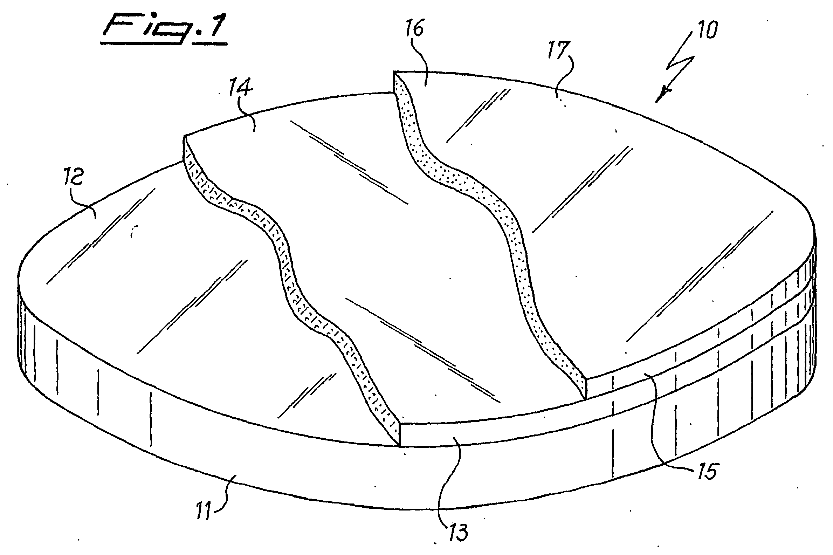

Figure 1 shows, in a partially cut-out view, a support of the invention in its simplest embodiment. The support, 10, comprises a base, 11; this has the only function of mechanical backing the support and the devices deriving therefrom, and the thickness of support 10 (of the order of one millimeter) is given nearly completely from this base's thickness. On surface 12 of base 11 there is a continuous layer 13 of a gas absorbing material, 14, whose upper surface is covered with another layer 15 of a material 16 compatible with the ICs or MMs production process, which are produced on the upper surface 17 of layer 15.

The material of base 11 can be a metal, a ceramic, a glass or a semiconductor, preferably silicon.

Material 14 can be any known material chosen among the materials commonly referred to as getters, capable of sorbing various gas molecules, and the drier materials, specific for moisture absorption.

In the case of a getter material, this can be for example a metal as Zr, Ti, Nb, Ta, V; an alloy among these metals or among these and one or more elements, chosen among Cr, Mn, Fe, Co, Ni, Al, Y, La and rare-earths, such as binary alloys Ti-V, Zr-V, Zr-Fe and Zr-Ni, ternary alloys Zr-Mn-Fe or Zr-V-Fe or alloys with more components. Preferred getter materials for this application are titanium, zirconium, the alloy having weight percentage composition Zr 84%-Al 16%, produced and sold from applicant under the name St 101® , the alloy having weight percentage composition Zr 70%-V 24.6%-Fe 5.4%, produced and sold from applicant under the name St 707® and the alloy having weight percentage composition Zr 80.8%-Co 14.2%-TR 5% (wherein TR is a rare-earth, yttrium, lanthanum or mixtures thereof), produced and sold from applicant under the name St 787. Getter material layer 13 can be obtained by different techniques, such as evaporation, deposition from metallorganic precursors, or by techniques known in the field as "laser ablation" and "e-beam deposition"; preferably this layer is obtained by sputtering.

In the case of drier materials, these are preferably chosen among the oxides of alkali or alkaline-earth metals; particularly preferred is the use of calcium oxide, CaO, that does not pose safety or environmental problems during the phases of production, use or disposal of devices containing it. A layer 13 of oxide may be obtained for instance through the so-called "reactive sputtering" technique, depositing the alkali or alkaline-earth metal of interest under an atmosphere of a rare gas (generally argon) in which a low percentage of oxygen is present, so that the metal is converted to its oxide during deposition.

Layer 13 can have a thickness within the range of about 0,1 and 5 µm: with thickness values lower than the indicated ones, the gas sorption capacity of layer 13 is excessively reduced, while with higher thickness values deposition times are extended without real advantages on sorption properties.

Material 16 is one of the materials which are usually used as substrate in solid state devices production; it can be a so-called III-V material (for example, GaAs o InP), or preferably silicon. Layer 16 can be obtained by sputtering, by epitaxy, by CVD or by others techniques known in the field. The thickness of layer 16 is generally lower than 50 µm and preferably within the range of about 1 to 20 µm. This layer performs two functions: it protects the gas absorbing material from the contact with gases until this latter is exposed (by partial and localized removal of layer 16), and acts as an anchorage for the layers which are subsequently deposed thereon to construct ICs, microoptoelectronic devices or MMs, or it can be even itself the layer in which these devices are formed (for example the micromachine moving parts can be obtained in this layer by removal of parts thereof). The upper surface of layer 16 can also be treated so as to modify its chemical composition, for example forming an oxide or a nitride, in view of the following operations of devices production.

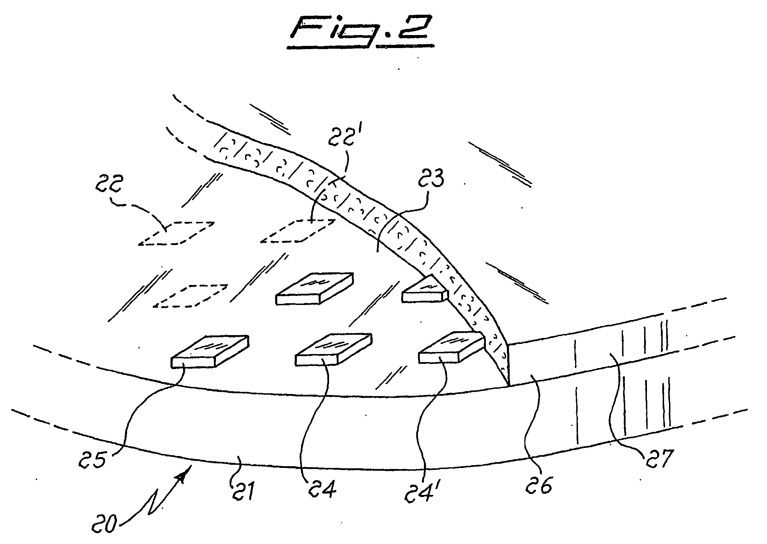

Figure 2 shows a second possible embodiment of the support according to the invention; also in this case the support is represented partially in cut-out view, and besides in this case also the lateral dimensions of the various deposits on the base of gas absorption material are exaggerated for the sake of clarity. Support 20 comprises a base 21. In areas 22, 22', ... of surface 23 of this base discrete deposits, 24, 24', ..., of gas absorbing material 25 are obtained; these are then covered with a layer 26 of material 27. Base 21 is of the same kind and size of base 11 of support 10; analogously materials 25 and 27 are respectively of the same kind of materials 14 and 16, described with reference to device 10.

Deposits 24, 24', ..., are as thick as layer 13 of support 10. These deposits are, however, discrete, and have lateral dimensions generally lower than 500 µm and variable within wide ranges depending on the final destination device: for example, if use is expected in ICs, the lateral dimensions will be within the range of some micron or less, while in the case of MMs, these dimensions can be comprised between a few tens and a few hundreds of microns.

Layer 26 has a variable thickness, lower in the areas over deposits 24, 24', ..., and higher in the areas cleared from these deposits, adhering to surface 23 in these areas. The thickness of this layer in the areas over the deposits has the same values of layer 15 of support 10, while in areas clear from deposits 24, 24', ..., its thickness will be increased of the thickness of these deposits. To help adherence, layer 26 is preferably made with the same material of base 21; the preferred combination is silicon (mono- or polycrystalline) for base 21, and silicon grown through epitaxy for layer 26.

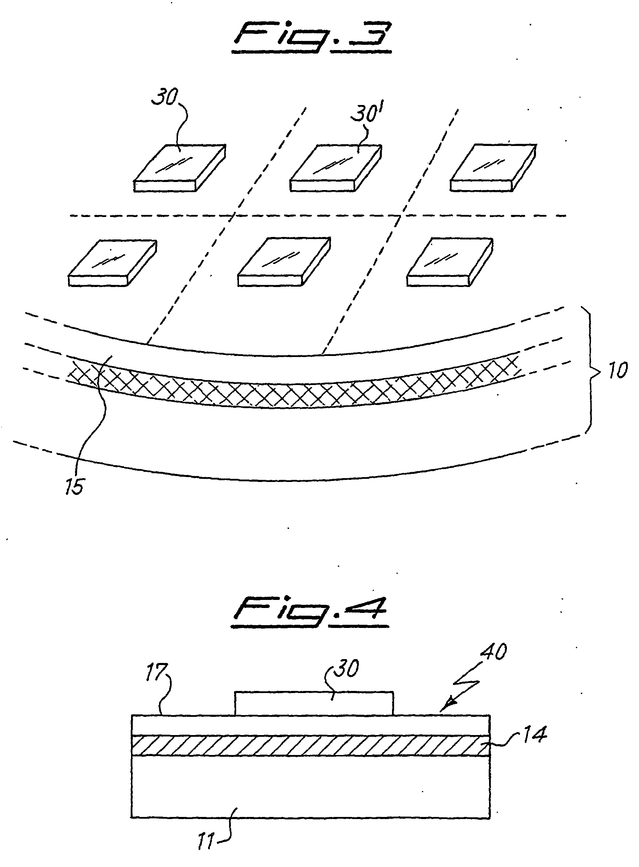

Figures 3 and 4 show a possible use of support 10 in ICs production. On upper surface 17 of support 10, formed of a layer 15 for example of silicon, solid state microelectronic circuits, schematized as elements 30, 30', ..., are obtained with known techniques. Support 10 is then cut along dotted lines in figure 3, thus obtaining single ICs devices: one of these is schematized in figure 4, showing a integrated circuit 40 obtained on a part of support 10 that has integrated, "buried" under surface 17, a layer 13 of gas absorbing material 14. This layer 13 is capable of sorbing gases, especially hydrogen, which may diffuse through the different layers of the device, thus preventing or reducing the contamination of integrated circuit 40.

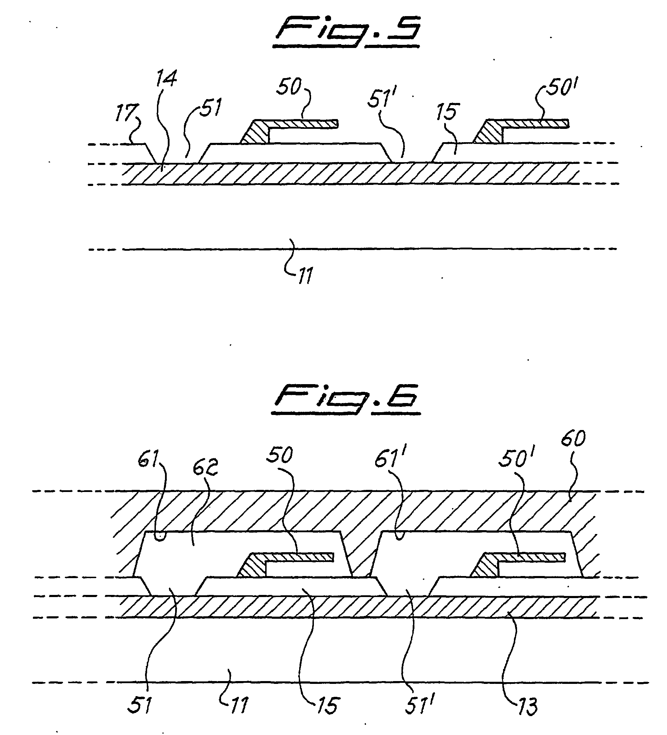

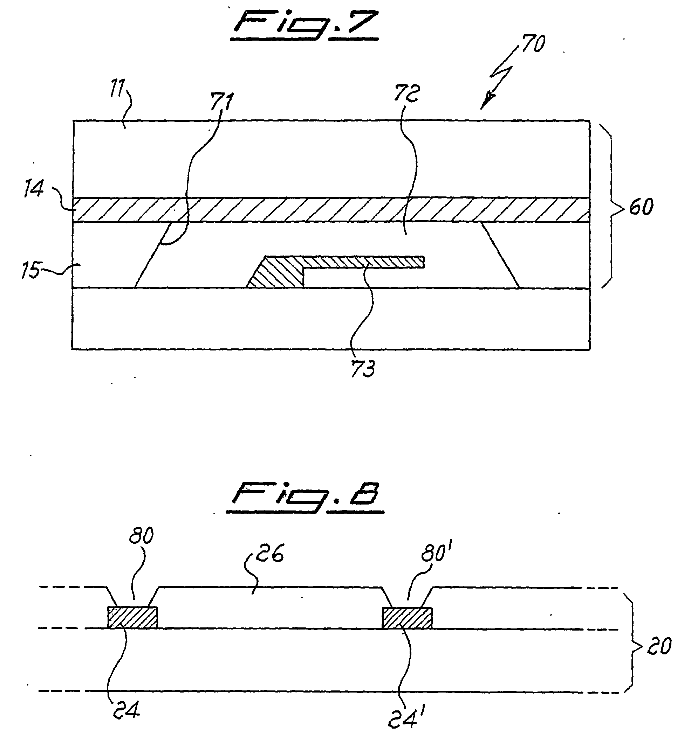

In the case of MMs production, on surface 17 of the support are produced structures, schematized in figure 5 as elements 50, 50', ..., which comprise the mobile parts of the micromachine. When the production of structures 50, 50', ... (including leads for the electric connection of every single micromachine with the outside, not showed in the drawing) is finished, the support is subjected to a localized removal operation of layer 15, in areas of surface 17 which are cleared from said structures, thus forming passages 51, 51', ..., which expose the gas absorbing material 14; then a covering element 60 is placed over the so treated support 10, (the assembly of this and support 10 is showed in cross-section in figure 6), this element will be realized, generally, with the same materials of base 11 and it should be easily fixable to surface 17 (the use of silicon is preferred): this element 60 can have hollows, 61, 61', ..., (case shown in figure) in correspondence with areas wherein, on support 10, structures 50, 50', ..., have been obtained and portions of layer 13 have been exposed; in particular, each of said hollows will be such that, when support 10 and element 60 are fixed together, a space 62 is obtained wherein a structure like 50, 50', ..., and a passage 51 giving access to material 14 are contained, so that this latter is in direct contact with space 62 and is able to sorb gases possibly present or released during time in said space. Finally, single micromachines are obtained by cutting the assembly made up of support 10 and element 60 along their adhesion areas.

In a variation of the micromachines production process summarized above, the localized removal of layer 15 is carried out before the manufacturing steps of structures 50, 50'.

In another variation of the process outlined above, whose final result is micromachine 70 shown in figure 7, the support of the invention is used as element 60. In this case, the substrate on which the micromachine is formed is a traditional one, without integrated gas absorbing layer. Support 10 of the invention is subjected to a localized removal treatment of layer 15, thus forming at the same time a hollow 71 constituting space 72 for housing mobile structure 73, and the passage giving access to material 14.

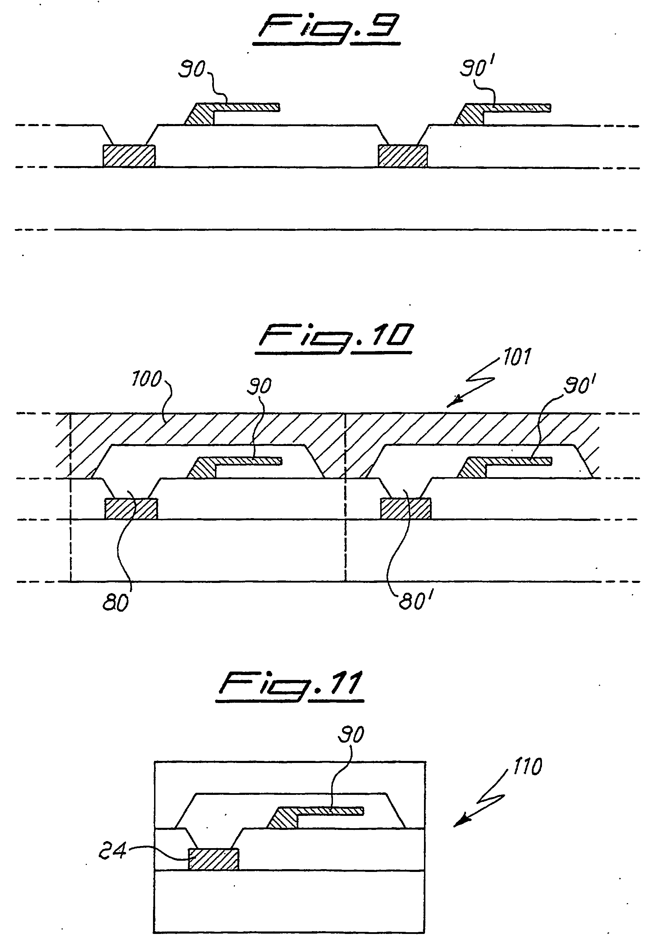

The use of a support of type 20 will be illustrated only in relation to the use as a support on whose surface a micromachine is formed (use similar to that represented in figures 5 and 6), but, obviously, this can also be used as support for ICs production (as described with reference to figures 3 and 4) or as a covering element in micromachines (as described with reference to figure 7). Support 20 is subjected to a localized removal treatment of layer 26 in correspondence to deposits 24, 24', ..., thus obtaining on the support passages 80, 80', ..., as shown in section in figure 8, ready for the sequence of steps for micromachines production. Moving structures (schematized as elements 90, 90') of figure 9 are then formed on this support; afterwards, a covering element 100 is fixed to support 20, in areas cleared from moving structures 90, 90', ... and from passages 80, 80', ...., thus obtaining assembly 101 shown in section in figure 10; finally, by cutting assembly 101 along lines (dotted in figure) comprised in adhesion areas between support 20 and element 100, the micromachine 110 shown in section in figure 11 is obtained.

Due to its way of use, support of type 20 must be produced when final application is known. In particular, especially in case of the micromachines, it is important to know the lateral size of the moving structures (50, 50', ..., 73 or 90, 90'...) as well as the lateral size of the hollows (61, 61', ... or 71) to be produced next, so to be able to define correctly the lateral size and reciprocal distance of deposits 24, 24', ...; in this way it is assured that the hollows giving access to the gas absorbing material do not interfere with moving structure, but also that they are contained in the perimeter of space 62 or 72 wherein the micromachine is housed. This correct sizing can be carried out by obtaining, from final circuits producers, drawings, even preliminary, of devices to be produced on support 20.

## Claims

1. A support (10; 20) with integrated deposit of gas absorbing material for manufacturing microelectronic, microoptoelectronic or micromechanical devices, comprising a base (11; 21) having functions of mechanical backing, a continuous (13) or discontinuous (24, 24', ...) deposit of a gas absorbing material (14; 25) on a surface (12; 23) of said base, said gas absorbing material (14; 25) being selected from a getter material or a drier material, and a layer (15; 26) completely covering said gas absorbing material deposit, made of a material (16; 27) compatible with the manufacture of microelectronic, microoptoelectronic or micromechanical devices or parts thereof.

2. A support (10) according to claim 1, wherein said deposit (13) of gas absorbing material is continuous over the entire surface (12) of said base (11).

3. A support (20) according to claim 1, wherein said deposit of gas absorbing material is in the form of discrete deposits (24, 24", ...) on said surface (23) of said base (21).

4. A support according to claim 1 wherein said base (11; 21) is made of a material selected among a metal, a ceramic, a glass or a semiconductor.

5. A support according to claim 4, wherein said material is silicon.

6. A support according to claim 1 wherein said gas absorbing material is a getter material.

7. A support according to claim 6 wherein said getter material is selected among metals Zr, Ti, Nb, Ta, V, alloys among these metals or alloys among these metals and one or more elements selected among Cr, Mn, Fe, Co, Ni, Al, Y, La and rare-earths.

8. A support according to claim 7 wherein said getter material is titanium.

9. A support according to claim 7 wherein said getter material is zirconium.

10. A support according to claim 7 wherein said getter material is an alloy having a weight percentage composition Zr 84%-Al 16%.

11. A support according to claim 7 wherein said getter material is an alloy having a weight percentage composition Zr 70%-V 24.6%-Fe 5.4%.

12. A support according to claim 7 wherein said getter material is an alloy having a weight percentage composition Zr 80.8%-Co 14.2%-TR 5%, wherein TR means a rare earth, yttrium, lanthanum or mixtures thereof.

13. A support according to claim 1 wherein said gas absorbing material is a drier. material.

14. A support according to claim 13 wherein said drier material is chosen amomg the oxides of alkali or alkaline-earth metals.

15. A support according to claim 14 wherein said drier material is calcium oxide.

16. A support according to claim 1 wherein said continuous or discontinuous deposit of gas absorbing material has a thickness within the range of 0.1 to 5 µm.

17. A support according to claim 1 wherein said material compatible with the manufacture of microelectronic, microoptoelectronic or micromechanical devices or parts thereof is a semiconductor material.

18. A support according to claim 17 wherein said material is silicon.

19. A support according to claim 1 wherein said layer of material compatible with the manufacture of microelectronic, microoptoelectronic or micromechanical devices or parts thereof, has a thickness lower than 50 µm.

20. A support according to claim 19 wherein said thickness is within the range of 1 to 20 µm.

21. Use of a support of claim 1 as covering element (60) in the production of a micromechanical device (70).

## Patentansprüche

1. Träger (10; 20) mit integrierter Ablagerung von gasabsorbierendem Material zum Fertigen mikroelektronischer, mikrooptoelektronischer oder mikromechanischer Bausteine, der eine Basis (11; 21) mit Funktionen zum mechanischen Tragen, eine kontinuierliche (13) oder diskontinuierliche (24, 24', ...) Ablagerung eines gasabsorbierenden Materials (14; 25) auf einer Oberfläche (12; 23) der Basis, wobei das gasabsorbierende Material (14; 25) aus einem Gettermaterial oder einem Trockenmaterial ausgewählt ist, und eine Schicht (15; 26), die die Ablagerung von gasabsorbierendem Material vollständig bedeckt und aus einem Material (16; 27) gefertigt ist, das mit der Fertigung von mikroelektronischen, mikrooptoelektronischen oder mikromechanischen Bausteinen oder Teilen davon kompatibel ist, umfasst.

2. Träger (10) nach Anspruch 1, wobei die Ablagerung (13) von gasabsorbierendem Material über die gesamte Oberfläche (12) der Basis (11) kontinuierlich verläuft.

3. Träger (20) nach Anspruch 1, wobei die Ablagerung von gasabsorbierendem Material in der Form von einzelnen Ablagerungen (24, 24', ...) auf der Oberfläche (23) der Basis (21) vorliegt.

4. Träger nach Anspruch 1, wobei die Basis (11; 21) aus einem Material gefertigt ist, das unter einem Metall, einem keramischen Material, einem Glas oder einem Halbleiter ausgewählt ist.

5. Träger nach Anspruch 4, wobei das Material Silizium ist.

6. Träger nach Anspruch 1, wobei das gasabsorbierende Material ein Gettermaterial ist.

7. Träger nach Anspruch 6, wobei das Gettermaterial unter den Metallen Zr, Ti, Nb, Ta, V, Legierungen dieser Metalle oder Legierungen dieser Metalle und einem oder mehreren unter Cr, Mn, Fe, Co, Ni, Al, Y, La und Seltenerdmetallen ausgewählten Elementen ausgewählt ist.

8. Träger nach Anspruch 7, wobei das Gettermaterial Titan ist.

9. Träger nach Anspruch 7, wobei das Gettermaterial Zirkonium ist.

10. Träger nach Anspruch 7, wobei das Gettermaterial eine Legierung ist, die eine Gewichtsprozentzusammensetzung von Zr 84 % - Al 16 % aufweist.

11. Träger nach Anspruch 7, wobei das Gettermaterial eine Legierung ist, die eine Gewichtsprozentzusammensetzung von Zr 70 % - V 24,6 % - Fe 5,4 % aufweist.

12. Träger nach Anspruch 7, wobei das Gettermaterial eine Legierung ist, die eine Gewichtsprozentzusammensetzung von Zr 80,8 % - Co 14,2 % - TR 5 % aufweist, wobei TR für ein Seltenerdmetall, Yttrium, Lanthan oder Gemische davon steht.

13. Träger nach Anspruch 1, wobei das gasabsorbierende Material ein Trockenmaterial ist.

14. Träger nach Anspruch 13, wobei das Trockenmaterial unter den Oxiden von Alkali- oder Erdalkalimetallen ausgewählt ist.

15. Träger nach Anspruch 14, wobei das Trockenmaterial Calciumoxid ist.

16. Träger nach Anspruch 1, wobei die kontinuierliche oder diskontinuierliche Ablagerung von gasabsorbierendem Material eine Dicke im Bereich von 0,1 bis 5 µm aufweist.

17. Träger nach Anspruch 1, wobei das mit der Fertigung von mikroelektronischen, mikrooptoelektronischen oder mikromechanischen Bausteinen oder Teilen davon kompatible Material ein Halbleitermaterial ist.

18. Träger nach Anspruch 17, wobei das Material Silizium ist.

19. Träger nach Anspruch 1, wobei die Schicht von mit der Fertigung von mikroelektronischen, mikrooptoelektronischen oder mikromechanischen Bausteinen oder Teilen davon kompatiblem Material eine Dicke von weniger als 50 µm aufweist.

20. Träger nach Anspruch 19, wobei die Dicke im Bereich von 1 bis 20 µm liegt.

21. Verwendung eines Trägers gemäß Anspruch 1 als Abdeckungselement (60) bei der Herstellung eines mikromechanischen Bausteins (70).

## Revendications

1. Support (10 ; 20) avec dépôt intégré de matériau absorbant de gaz pour la fabrication de dispositifs microélectroniques, microoptoélectroniques ou micromécaniques, comprenant une base (11 ; 21) présentant des fonctions de renforcement mécanique, un dépôt continu (13) ou discontinu (24, 24', ...) d'un matériau absorbant de gaz (14 ; 25) sur une surface (12 ; 23) de ladite base, ledit matériau absorbant de gaz (14 ; 25) étant choisi parmi un matériau getter ou un matériau dessiccateur, et une couche (15 ; 25) recouvrant complètement ledit dépôt de matériau absorbant de gaz, réalisé en un matériau (16 ; 27) compatible avec la fabrication de dispositifs microélectroniques, microoptoélectroniques ou micromécaniques ou des parties de ceux-ci.

2. Support (10) selon la revendication 1, dans lequel ledit dépôt (13) de matériau absorbant de gaz est continu sur la surface entière (12) de ladite base (11).

3. Support (20) selon la revendication 1, dans lequel ledit dépôt de matériau absorbant de gaz est sous la forme de dépôts discrets (24, 24', ...) sur ladite surface (23) de ladite base (21).

4. Support selon la revendication 1, dans lequel ladite base (11 ; 21) est réalisée en un matériau choisi parmi un métal, une céramique, un verre ou un semi-conducteur.

5. Support selon la revendication 4, dans lequel ledit matériau est du silicium.

6. Support selon la revendication 1, dans lequel ledit matériau absorbant de gaz est un matériau getter.

7. Support selon la revendication 6, dans lequel ledit matériau getter est choisi parmi les métaux Zr, Ti, Nb, Ta, V, des alliages parmi ces métaux ou des alliages parmi ces métaux et un ou plusieurs élément(s) choisi(s) parmi Cr, Mn, Fe, Co, Ni, Al, Y, La et des terres rares.

8. Support selon la revendication 7, dans lequel ledit matériau getter est du titane.

9. Support selon la revendication 7, dans lequel ledit matériau getter est du zirconium.

10. Support selon la revendication 7, dans lequel ledit matériau getter est un alliage présentant une composition en pourcentage en poids 84% Zr-16% Al.

11. Support selon la revendication 7, dans lequel ledit matériau getter est un alliage présentant une composition en pourcentage en poids 70% Zr-24,6% V-5,4% Fe.

12. Support selon la revendication 7, dans lequel ledit matériau getter est un alliage présentant une composition en pourcentage en poids 80,8% Zr-14,2% Co-5% TR, dans laquelle TR renvoie à une terre rare, de l'yttrium, du lanthane ou des mélanges de ceux-ci.

13. Support selon la revendication 1, dans lequel ledit matériau absorbant de gaz est un matériau dessiccateur.

14. Support selon la revendication 13, dans lequel ledit matériau dessiccateur est choisi parmi des oxydes d'alcalin ou des métaux alcalino-terreux.

15. Support selon la revendication 14, dans lequel ledit matériau dessiccateur est de l'oxyde de calcium.

16. Support selon la revendication 1, dans lequel ledit dépôt continu ou discontinu de matériau absorbant de gaz présente une épaisseur comprise dans la gamme allant de 0,1 à 5 µm.

17. Support selon la revendication 1, dans lequel ledit matériau compatible avec la fabrication de dispositifs microélectroniques, microoptoélectroniques ou micromécaniques ou des parties de ceux-ci, est un matériau semi-conducteur.

18. Support selon la revendication 17, dans lequel ledit matériau est du silicium.

19. Support selon la revendication 1, dans lequel ladite couche de matériau compatible avec la fabrication de dispositifs microélectroniques, microoptoélectroniques ou micromécaniques ou des parties de ceux-ci, présentent une épaisseur inférieure à 50 µm.

20. Support selon la revendication 19, dans lequel ladite épaisseur est comprise dans la gamme allant de 1 à 20 µm.

21. Utilisation d'un support selon la revendication 1 comme élément recouvrant (60) dans la production d'un dispositif micromécanique (70).
